(19) Europäisches Patentamt / European Patent Office / Office européen des brevets

(11) **EP 2 912 500 B1**

(12) **EUROPÄISCHE PATENTSCHRIFT**

(45) Veröffentlichungstag und Bekanntmachung des Hinweises auf die Patenterteilung:
**11.07.2018   Patentblatt 2018/28**

(21) Anmeldenummer: **13788694.1**

(22) Anmeldetag: **15.10.2013**

(51) Int Cl.:
*G02B 1/11* *(2015.01)*          *G02B 5/22* *(2006.01)*

(86) Internationale Anmeldenummer:
**PCT/EP2013/071488**

(87) Internationale Veröffentlichungsnummer:
**WO 2014/063953 (01.05.2014 Gazette 2014/18)**

(54) **HOCH ABSORBIERENDES SCHICHTSYSTEM, VERFAHREN ZUR HERSTELLUNG DES SCHICHTSYSTEMS UND DAFÜR GEEIGNETES SPUTTERTARGET**

HIGHLY ABSORBING LAYER SYSTEM, METHOD FOR PRODUCING THE LAYER SYSTEM AND SUITABLE SPUTTERING TARGET THEREFOR

SYSTÈME EN COUCHES HAUTEMENT ABSORBANT, PROCÉDÉ DE PRODUCTION DE CE SYSTÈME EN COUCHES ET CIBLE DE PULVÉRISATION APPROPRIÉE À CET EFFET

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.10.2012   DE 102012110113**
**20.12.2012   DE 102012112739**
**20.12.2012   DE 102012112742**

(43) Veröffentlichungstag der Anmeldung:
**02.09.2015   Patentblatt 2015/36**

(73) Patentinhaber:
• **Materion Advanced Materials Germany GmbH**
  **63450 Hanau (DE)**
• **Fraunhofer Gesellschaft zur Förderung der angewandten Forschung e.V.**
  **80686 München (DE)**

(72) Erfinder:
• **SCHLOTT, Martin**
  **63075 Offenbach (DE)**
• **KASTNER, Albert**
  **63457 Hanau (DE)**
• **SCHULTHEIS, Markus**
  **36103 Flieden (DE)**
• **WAGNER, Jens**
  **60322 Frankfurt (DE)**
• **SCHNEIDER-BETZ, Sabine**
  **63150 Heusenstamm (DE)**
• **DEWALD, Wilma**
  **38106 Braunschweig (DE)**
• **SZYSZKA, Bernd**
  **38108 Braunschweig (DE)**
• **SITTINGER, Volker**
  **38106 Braunschweig (DE)**

(74) Vertreter: **Kador & Partner PartG mbB**
**Corneliusstraße 15**
**80469 München (DE)**

(56) Entgegenhaltungen:
EP-A1- 0 852 266          EP-A1- 2 116 631
EP-A1- 2 336 811          EP-A1- 2 437 085
WO-A1-97/27997          DE-A1-102009 038 000
US-A1- 2004 115 362

**EP 2 912 500 B1**

**Beschreibung**

Technischer Hintergrund

Die vorliegende Offenbarung betrifft ein hoch absorbierendes Schichtsystem aus mindestens zwei Schichten, von denen eine einem Betrachter zugewandte Antireflexschicht ist, die aus einem dielektrischen Werkstoff besteht und mindestens eine weitere eine dem Betrachter abgewandte Absorberschicht. Die Erfindung betrifft ein Verfahren zur Herstellung eines derartigen Schichtsystems, umfassend die Abscheidung einer Absorberschicht durch DC- oder MF-Sputtern eines Sputtertargets in einer Sputter-Atmosphäre, die Argon enthält, sowie ein zur Durchführung des Verfahrens geeignetes Sputtertarget.

Stand der Technik

Licht absorbierende Schichtsysteme werden beispielsweise durch Abscheiden aufeinanderfolgender Schichten durch Kathodenzerstäubung (Sputtern) erzeugt. Dabei werden Atome oder Verbindungen aus einem Festkörper, dem Sputtertarget, durch Beschuss mit energiereichen Ionen (üblicherweise Edelgasionen) herausgelöst und gehen in die Gasphase über. Die in der Gasphase befindlichen Atome oder Moleküle werden schließlich durch Kondensation auf einem in der Nähe des Sputtertargets befindlichen Substrat abgeschieden und bilden dort eine Schicht aus. Beim "Gleichspannungssputtern" oder "DC-Sputtern" (direct current sputtering) wird zwischen dem als Kathode geschalteten Target und einer Anode (häufig das Anlagengehäuse) eine Gleichspannung angelegt. Durch Stoßionisation von Inertgasatomen bildet sich im evakuierten Gasraum ein Niederdruckplasma, dessen positiv geladene Bestandteile durch die angelegte Gleichspannung als dauerhafter Teilchenstrom in Richtung auf das Target beschleunigt werden und beim Aufprall Teilchen aus dem Target herausgeschlagen, die sich wiederum in Richtung auf das Substrat bewegen und sich dort als Schicht niederschlagen.

Das DC-Sputtern erfordert ein elektrisch leitfähiges Targetmaterial, da sich andernfalls das Target infolge des dauerhaften Stroms elektrisch geladener Teilchen aufladen und damit das Gleichspannungsfeld kompensieren würden. Andererseits ist gerade diese Sputtermethode geeignet, Schichten besonders hoher Qualität auf wirtschaftliche Weise zu liefern, so dass ihr Einsatz angestrebt wird. Dies trifft auch für das technologisch verwandte MF-Sputtern zu, bei dem zwei Sputtertargets wechselseitig im kHz-Rhythmus als Kathode und Anode geschaltet werden.

Licht absorbierende Schichtsysteme werden für verschiedene Anwendungen eingesetzte, wie etwa für solarthermische Anwendungen oder sogenannte "black matrix"-Schichten in Verbindung mit Flüssigkristall-Displays.

Bei den Solarabsorberschichten umfasst der Schichtaufbau typischerweise eine Cermetschicht und eine darunter liegende metallische Abschlussschicht, die als selektiver Reflektor dient. Die in die Cermetschicht eingelagerten leitfähigen oder metallischen Partikel haben Durchmesser von typischerweise 5-30 nm. Diese Schichtstapel weisen im solaren Spektralbereich (um 350 bis 1500 nm) einen hohen Absorptionsgrad auf, während ihr Absorptionsgrad im infraroten Spektralbereich gering ist. Für ihre industrielle Fertigung sind galvanische Beschichtungstechniken und ebenfalls PVD-Verfahren gebräuchlich. Beispiele für solche Schichtstapel sind Ni/NiO + Al und TiNx/TiO$_2$ + Cu. Eine aktuelle Übersicht gibt "Kennedy, C.E.; - Review of Mid- to High-Temperature Solar Selective Absorber Materials; NREL Technical Report (July 2002)".

Es sind auch "Cermet-Schichtsysteme" bekannt, bei denen Bereiche aus metallischer Phase in einer oxidischen Matrix eingelagert sind. Derartige Cermet-Schichtsystem sind jedoch schwierig ätzbar, da Oxid und eingebettete Metallpartikel unterschiedliche Ätzmittel benötigen und für die Oxide in der Regel Fluorid-Ionen benötigt werden. Auch Plasmaätzen hat sich als schwierig erwiesen. So wird beispielsweise bei Kombinationen aus einem Oxid und einem Edelmetall überwiegend das Oxid geätzt, so dass Metallpartikel übrig bleiben und damit die Sputteranlage und nachfolgende Substrate kontaminieren. Dasselbe gilt für nasschemisches Ätzen, beispielsweise mit Flusssäure.

Die vor allem bis zur Substratgeneration 5 eingesetzten Cr-basierten "black matrix Schichten" weisen außerdem den Nachteil auf, dass beim nasschemischen Ätzen giftige Cr-VI Verbindungen entstehen können.

EP0852266 offenbart ein bekanntes Sputtertarget.

Technische Aufgabenstellung

Aus den oben erörterten Gründen sind Schichtstrukturen erwünscht, die eine hohe Absorption und geringe Reflektion im sichtbaren Spektralbereich zeigen und die sich außerdem ohne das Entstehen giftiger Substanzen und ohne Partikelrückstände ätzen lassen. Metallische Schichten oder Schichtlagen erfüllen diese Voraussetzung nicht.

Andererseits - und dazu im gewissen Widerspruch stehend - sollen die Schichten aus Qualitätserwägungen vorzugsweise durch DC- oder MF-Sputtern herstellbar sein, was einen elektrisch leitenden Target-Werkstoff voraussetzt.

Der Erfindung liegt daher die Aufgabe zugrunde, ein Schichtsystem und ein für seine Herstellung geeignetes Sputtertarget bereitzustellen, die diese Anforderungen erfüllen.

Weiterhin liegt der Erfindung die Aufgabe zugrunde, eine Verwendung des erfindungsgemäßen Schichtsystems anzugeben.

Allgemeine Beschreibung der Erfindung

Die Erfindung wird durch ein Sputtertarget nach Anspruch 1 und ein Verfahren nach Anspruch 11 definiert.

Schichtsystem

Hinsichtlich des Schichtsystems wird diese Aufgabe ausgehend von einem Schichtsystem der eingangs genannten Gattung dadurch gelöst, dass die Absorberschicht aus einem Oxid oder aus einem Oxinitrid mit unterstöchiometrischem Sauerstoffgehalt besteht, und dass das Schichtsystem insgesamt im Wellenlängenbereich von 380 bis 780 nm eine visuelle Transmission Tv von weniger als 1 % und eine visuelle Reflexion Rv von weniger als 6 % aufweist sowie eine optische Absorption hat, die durch einen Absorptionsindex kappa von mindestens 0,70 bei einer Wellenlänge von 550 nm gekennzeichnet ist.

Das Schichtsystem soll für einen Betrachter optisch nicht transparent, also undurchsichtig erscheinen. Für eine starke Absorption im sichtbaren Spektralbereich (380-780nm) ist keine hohe Absorption bis hinauf zu 1.500nm (IR-Bereich) nötig, wie sie mit metallischen Schichtlagen erreichbar ist. Zumindest in der vom Betrachter aus gesehen hinteren Schichtlage - der Absorberschicht - ist eine geringe Transmission Tv von weniger als 1%, vorzugsweise weniger als 0,2 % im Wellenlängenbereich von 380 bis 780 nm zu gewährleisten. Darüber zeigt das erfindungsgemäße Schichtsystem eine besonders hohe optische Absorption, die zeichnet ist durch einen Absorptionsindex kappe (gemessen bei 550nm), der mindestens 0,70, bevorzugt mindestens 1,0 und besonders bevorzugt mindestens 1,5 beträgt. Für den Absorptionsindex kappa gilt hierbei:

$$n*kappa=k$$

mit n=Realteil der komplexen Brechzahl und k=Extinktionskoeffizient, der wiederum in die komplexe Brechzahl

$$N=n+i*k$$

eingeht und mittels dem ein Dämpfungsbeitrag durch den Imaginärteil im Brechungsindex der Schichten des Schichtsystems berücksichtigt wird.

Grundsätzlich ist eine Absorberschicht mit möglichst hoher Absorption erwünscht, so dass es keine klar begrenzende Obergrenze für kappa gibt. Allerdings kann bei sehr hohen kappa-Werten oberhalb von 2,5 eine effektive Entspiegelung der Absorberschicht zunehmend schwieriger werden.

Licht absorbierende Schichten können durch lichtstreuende oder absorbierende Einlagerungen von Partikeln oder Ausscheidungen in einer ansonsten transparenten Schichtmatrix erhalten werden. Werden derartige Schichten im weiteren Fertigungsprozess einem Ätzvorgang unterworfen, können jedoch Partikel oder Ausscheidungen ein anderes Ätzverhalten zeigen als die Schichtmatrix und beim Ätzen des Schichtsystems zu einer unerwünschten Partikelbildung führen. Dies ist insbesondere bei schwer ätzbaren Metallpartikeln der Fall, wie etwa bei Edelmetallpartikeln.

Um dies zu vermeiden, ist beim Schichtsystem vorgesehen, dass die Absorberschicht lichtabsorbierend wirkt, indem sie aus einem unterstöchiometrischen Oxid oder einem unterstöchiometrischen Oxinitrid besteht. Diese Substanzen haben unbesetzte O- oder N-Valenzen. Im Fall des Oxinitrids können diese sowohl als Stickstoff- als auch als Sauerstoffmangel interpretiert werden kann. Sofern nicht ausdrücklich anderes gesagt wird, soll der Einfachheit halber bei den folgenden Erläuterungen ein "unterstöchiometrischer Stickstoffgehalt" mitgelesen werden, auch wenn auf "Unterstöchiometrie" allgemein oder auf "unterstöchiometrischen Sauerstoffgehalt" oder "Sauerstoffmangel" Bezug genommen wird.

Weitab ihrer stöchiometrischen Zusammensetzung vorliegende Substanzen zeigen eine Anzahl von Sauerstoffmangeldefekten, die sich spektroskopisch anhand einer spezifischen oder verschwommenen Absorption im sichtbaren Wellenlängenbereich äußern. Dadurch wird die Absorberschicht allein durch den Sauerstoffmangel im Wellenlängenbereich von 380 bis 780 nm optisch undurchlässig, ohne dass dafür kristalline Partikel oder Ausscheidungen erforderlich sind.

Um nicht nur eine hohe Absorption, sondern zugleich auch eine geringe Reflexion zu erreichen, hat das Schichtsystem jedoch mindestens zwei Schichtlagen. Die Absorberschicht befindet sich unmittelbar oder mittelbar - über eine Zwischenschicht - auf einer Antireflexschicht. Diese dient im Wesentlichen als "Reflexionsanpassungsschicht". Ihr Brechungsindex liegt vorzugsweise zwischen dem Brechungsindex des an sie unmittelbar angrenzenden Mediums, wie etwa einem Substrat oder Luft und an dem Brechungsindex der Absorberschicht oder einer etwaigen Zwischenschicht. Ihre Dicke ist so einzustellen, dass die visuelle Reflexion Rv des weniger als 6%, vorzugsweise weniger als 2%, beträgt.

Als visuelle Reflexion Rv wird dabei die auf Augenempfindlichkeit normierte visuelle Reflexion verstanden, die aus der Gesamtreflexion des Schichtsystems unter Abzug der Reflexion an der Grenzfläche zwischen einem Glassubstrat und dem an dieses betrachterseitig angrenzende Medium berechnet wird. Die auf die Augenempfindlichkeit normierte Transmission Tv beträgt weniger als 1%, bevorzugt weniger als 0,2%.

Die Berechnung der visuellen Transmission / Reflexion (Tv, Rv) werden die Messwerte des Spektrometers mit den genormten Faktoren der Augenempfindlichkeit gefaltet und "aufintegriert" beziehungsweise summiert. Diese Faktoren der Augenempfindlichkeit sind in der DIN EN 410 festgelegt.

Bei einer Ausführungsform des Schichtsystems ist die Antireflexschicht auf einem Substrat aus lichtdurchlässigem Werkstoff aufgebracht, das in dem Fall als Träger dient. Hierbei liegt die Antireflexschicht dem Träger näher als die Absorberschicht. Üblicherweise handelt es sich bei dem Substrat um eine Glasplatte, einen Kunststoff-Träger oder eine Folie. Auf die Antireflexschicht folgt unmittelbar oder über eine oder mehrere Zwischenschichten die Absorberschicht, die mit weiteren funktionalen Schichten versehen sein kann.

Die wesentliche Funktion der Absorberschicht ist eine möglichst hohe Absorption der über die Antireflexschicht einfallenden optischen Strahlung. Parameter zur Erfüllung dieser Funktion sind außer dem Werkstoff der Absorberschicht ihre Schichtdicke und der Grad des Sauerstoffmangels. Je größer die Schichtdicke und der Sauerstoffmangel sind, umso höher sind elektrische Leitfähigkeit und Absorptionsvermögen der Absorberschicht. Diese Parameter werden auf einen optimalen Kompromiss zwischen hoher Absorption des Schichtsystems einerseits und einer niedrigen elektrischen Leitfähigkeit andererseits ausgelegt. Hinsichtlich des Werkstoffs hat es sich als vorteilhaft erwiesen, wenn die Absorberschicht als Hauptkomponente Oxide der Metalle Nb, Ti, Mo, W, V oder deren Mischungen enthält.

Diese Oxide und die daraus abgeleiteten stickstoffhaltigen Oxinitride zeigen bei Sauerstoffmangel (im Fall von Oxinitriden auch als Stickstoffmangel zu interpretieren) eine ausgeprägte Absorption im sichtbaren Wellenlängenbereich. Diese Werkstoffe haben außerdem den Vorteil, dass unterstöchiometrische Phasen nicht dazu neigen, schwer ätzbare Strukturen, wie kristalline Ausscheidungen, Segregations-Strukturen oder Metallcluster zu bilden.

In dem Zusammenhang ist es besonders vorteilhaft, wenn die Absorberschicht eine optisch homogene Struktur hat in dem Sinne, dass sie keine mittels Röntgendiffraktometermessungen erfassbaren kristallinen Strukturen aufweist.

Hiermit ergibt sich dann auch ein homogenes Ätzverhalten, wie beispielsweise beim Ätzen mit Fluorid-Ionen oder Ansätzen auf der Basis von $KOH+H_2O_2$. Die so charakterisierten Schichten zeigen auch bei transelektronenmikroskopischer Betrachtung keine Strukturen bis hinunter zu der Auflösungsgrenze von 2 nm. Thermodynamisch ist die amorphe Struktur jedoch instabil, so dass sich durch Tempern oder Aufheizen kristalline Ausscheidungen bilden können.

Für die Ausbildung der dielektrischen Antireflexschicht kommen grundsätzlich und bevorzugt dieselben Substanzen in Betracht wie für die Absorberschicht, jedoch dann mit voller Stöchiometrie oder allenfalls mit einem weniger ausgeprägten Sauerstoffmangel. Es hat sich sogar als vorteilhaft erwiesen, wenn auch die Antireflexschicht einen gewissen Sauerstoffmangel aufweist, wobei der Sauerstoffgehalt aber mindestens 94 % des stöchiometrischen Sauerstoffgehalts beträgt. Dadurch erzeugt nicht nur die Absorberschicht, sondern auch die Antireflexschicht eine gewisse Absorption, so dass die Gesamtdicke des Schichtsystems zur Gewährleistung der erforderlichen Gesamt-Absorption geringer gehalten werden kann.

Es sind aber auch andere, in der Literatur zur Antireflexbeschichtung eingesetzte dielektrische Schichtsysteme geeignet, beispielsweise AlN, $SnO_2$, $Si_3N_4$, $HfO_2$, $TiO_2$, $Al_2O_3$, Siliciumoxinitrid, $Nb_2O_5$, $MoO_3$, $WO_3$, $V_2O_5$, ZnO oder deren Mischungen.

Die Funktion der Antireflexschicht, nämlich die Reflexion des einfallenden Lichts im sichtbaren Wellenlängenbereich möglichst gering zu halten, wird vorteilhafterweise dadurch erfüllt, dass sie auf einem Substrat aufgebracht ist und einen Brechungsindex $n_R$ hat, für den gilt: $n_S < n_R < n_A$, wobei $n_S$ der Brechungsindex des Substrats und $n_A$ der Brechungsindex der Absorberschicht sind.

Obwohl es technisch einfacher ist, eine Doppelschicht aus Antireflexschicht und Absorberschicht auszuführen, ist auch ein Aufbau des Schichtsystems aus mehreren, in ihrer Sauerstoff-Unterstöchiometrie abgestuften Schichten oder auch eine Gradientenschicht möglich, die in Blickrichtung des Betrachters aus gesehen kontinuierlich sauerstoffärmer wird.

Ein optimaler Kompromiss zwischen möglichst hoher optischer Absorption einerseits und guter Entspiegelung und Ätzbarkeit andererseits ergibt sich, wenn der Sauerstoffgehalt der Absorberschicht zwischen 65 und 90%, vorzugsweise zwischen 70 und 85% des stöchiometrischen Sauerstoffgehalts beträgt.

Der Absorberschicht fehlen dabei zwischen 10 und 35 %, vorzugsweise zwischen 15 und 30 % der Sauerstoffatome, die in einer voll stöchiometrischen, dielektrischen Schicht anzutreffen wären. Bei hohen Sauerstoffdefiziten oberhalb von 35 % wird die Schicht zu metallähnlich und die Reflexion steigt an. Außerdem können dann beim Ätzen auch zunehmend Rückstände entstehen.

Mit zunehmender Dicke nimmt die Absorption zu. Im Sinne eines ausreichend hohem Absorptionsvermögen hat die Absorberschicht eine Dicke von weniger als 400 nm, vorzugsweise im Bereich von 140 bis 250 nm.

Im Sinne einer möglichst geringen Reflexion in Gegenrichtung zum einfallenden Licht und einer guten Reflexionsanpassung an die Absorberschicht hat die Antireflexschicht eine Dicke von weniger als 55 nm, vorzugsweise im Bereich von 35 bis 50 nm.

Im Hinblick auf die Herstellkosten ist die Gesamtdicke des Schichtsystems so klein wie möglich, um eine vorgegebene maximale Transmission einzuhalten. Wesentliche Parameter sind dabei der Sauerstoffmangel und die Dicke der Absorberschicht. Die erforderliche Mindestdicke kann durch Versuche einfach ermittelt werden. Typischerweise liegt die Gesamtdicke von Antireflexschicht und Absorberschicht im Bereich von 180 bis 455 nm, bevorzugt im Bereich von 190 bis 300 nm.

Das erfindungsgemäße Sputtertarget

Am einfachsten wäre es metallische Targets einzusetzen, wobei der Sauerstoffmangel der Absorberschicht sich beispielsweise durch teilreaktives Sputtern der Metalltargets unter unterschiedlichen Sauerstoffzugaben einstellen ließe. Dies erfordert jedoch eine exakte und konstante Einstellung des Sauerstoffgehalt in der Targetumgebung, was häufig mit einer geringen Prozessstabilität einhergeht und insbesondere bei großflächigen Beschichtungen an technologische Machbarkeitsgrenzen stößt.

Um diesen Nachteil zu vermeiden, ist beim erfindungsgemäßen Sputtertarget vorgesehen, dass es aus einem oxidischen Werkstoff mit Sauerstoffmangel besteht, der entweder durch eine reduzierte Oxidphase von unterstöchiometrischem Oxid oder Oxinitrid auf der Basis von $Nb_2O_{5-x}$, $TiO_{2-x}$, $MoO_{3-x}$, $WO_{3-x}$, $V_2O_{5-x}$ (x>0) oder deren Mischungen allein, oder durch die reduzierte Oxidphase zusammen mit einer metallischen Beimischung eingestellt wird.

Die Oxide oder Nitride des Sputtertargets weisen einen Mangel an Sauerstoff oder Stickstoff im Vergleich zur stöchiometrischen Zusammensetzung auf. Damit ist das Sputtertarget auch ohne elektrisch leitende Phase oder schon bei einem geringen Anteilen derselben ausreichend elektrisch leitfähig, so dass es mittels DC- oder MF-Sputtern verarbeitet werden kann. Zu diesem Zweck beträgt sein spezifischer elektrischer Widerstand vorzugsweise weniger als 10 Ohm*cm und besonders bevorzugt weniger als 1 Ohm*cm.

Im erfindungsgemäßen Sputtertarget ist der Sauerstoffmangel des Schichtsystems im Wesentlichen bereits angelegt, indem der Sauerstoffmangel des Sputtertargets dem der jeweilig zu sputternden Schicht genau oder in etwa entspricht. Beim Sputtern sind die oben genannten unterstöchiometrischen Oxide oder Nitride in der Lage Sauerstoff oder Stickstoff aufzunehmen. Eine Feinjustierung der Schichtstöchiometrie kann somit durch geringe Zugaben an Reaktivgasen (insbesondere von Sauerstoff) erreicht werden, so dass die erwähnten technologischen Schwierigkeiten beim Absputtern von Metalltargets unter hochreaktiver Atmosphäre vermieden werden. Neben Sauerstoff ist auch die Zugabe anderer reaktiver Gase wie Stickstoff geeignet.

Der unterstöchiometrische Sauerstoffgehalt kann im Sputtertarget entweder allein durch unterstöchiometrisches Metalloxid eingestellt werden oder dadurch, dass stöchiometrische oder nur geringfügig unterstöchiometrisches und damit elektrisch leitfähiges Metalloxid zusätzlich mit metallischem Material vermischt wird. Die letztgenannte Ausführungsform ist in der Regel zu bevorzugen, da stark unterstöchiometrische Oxide mit bis 35 % Sauerstoffmangel schwer darstellbar sind. Die metallische Beimischung enthält bevorzugt mindestens eines der Elemente Nb, Ti, Mo, W, Ta und V.

Bevorzugt wird als Targetmaterial ein Werkstoff eingesetzt, der einen Sauerstoffmangel aufweist, der entweder allein durch eine reduzierte Oxidphase von unterstöchiometrischem und dadurch elektrisch leitfähigem Oxid oder Oxinitrid auf der Basis von $Nb_2O_{5-x}$, $TiO_{2-x}$, $MoO_{3-x}$, $WO_{3-x}$, $V_2O_{5-x}$ (mit x>0) oder deren Mischungen oder durch die reduzierte Oxidphase zusammen mit einer metallischen Beimischung eingestellt wird.

Der Sauerstoffmangel des Sputtertargets ist vorzugsweise durch einen Reduktionsgrad definiert, bei dem der Sauerstoffgehalt zwischen 65 und 90 %, besonders bevorzugt zwischen 70 und 85 % des stöchiometrischen Sauerstoffgehalts, beziehungsweise des stöchiometrischen Sauerstoff- und Stickstoffgehalts liegt.

Ein derartiges Sputtertarget zeichnet sich durch einen geringen elektrischen Widerstand aus, der vorteilhafterweise weniger als 10 Ohm*cm, bevorzugt weniger als 1 Ohm*cm beträgt.

Dabei hat es sich bewährt, wenn die metallische Beimischung mindestens 50%, vorzugsweise mindestens 70% zur Einstellung der Unterstöchiometrie der Absorberschicht beiträgt.

Beim Sputtern geben reduzierbare oxidische oder nitridische Bestandteile des Target-Werkstoffs Sauerstoff oder Stickstoff an die metallische Beimischung ab. Letztendlich wird ein vorgegebener Sauerstoff-Unterschuss in der abgeschiedenen Schicht eingestellt. Der Anteil der metallischen Beimischung im Target-Werkstoff ist vorzugsweise so ausgelegt, dass er 50 % oder mehr dieses Unterschusses ausmacht.

Besonders gute Ergebnisse werden für die Absorberschicht erhalten, wenn der Target-Werkstoff Nb und Mo sowie mindestens eines deren Oxide, vorzugsweise Nioboxid mit unterstöchiometrischem Sauerstoffgehalt enthält.

Eine besonders bevorzugte Ausführungsform des erfindungsgemäßen Sputtertargets besteht aus $Nb_2O_{5-x}$ und Mo mit x=0,01 - 0,3, wobei der Mo-Gehalt vorzugsweise zwischen 28 und 60 Gew.-%, besonders bevorzugt zwischen 36 und 50 Gew.-%, beträgt.

Bei einer alternativen und ebenfalls geeigneten Ausführungsform des Sputtertargets enthält dieses Ti und Mo sowie mindestens eines deren Oxide, wobei der Mo-Gehalt vorzugsweise zwischen 30 und 65 Gew.-%, bevorzugt zwischen 40 und 55 Gew.-%, beträgt.

Es hat sich als vorteilhaft erwiesen, wenn der Reduktionsgrad über die Dicke des Sputtertargets möglichst gleichbleibend ist. Daher weist das unterstöchiometrische Oxid oder Oxinitrid bevorzugt einen Reduktionsgrad auf, der an mindestens 5 Stellen über die Dicke des Sputtertargets gemessen um nicht mehr als +-5 % (relativ) um einen Mittelwert streut.

Der Reduktionsgrad wird durch Gewichtszunahme bei Reoxidation bei 1000°C an Luft gemessen. Zur Ermittlung der Streuung des Reduktionsgrads werden über die Dicke der Targetschicht mindestens fünf Proben mit einem Gewicht von 1g aus unterschiedlichen Dickenbereichen der Targetschicht genommen und an diesen Proben wird die Gewichtszunahme bei Reoxidation bei 1000°C an Luft ermittelt. Der Mittelwert ergibt sich als arithmetisches Mittel der gemessenen Gewichtszunahmen.

Der homogene Reduktionsgrad trägt zu einer hohen Prozessstabilität beim Sputterprozess und zur Erzeugung von Sputterschichten mit reproduzierbaren Eigenschaften bei.

Im Hinblick hierauf hat es sich auch bewährt, wenn die metallische Beimischung einen Metallgehalt definiert, der an mindestens 5 Stellen über die Dicke des Sputtertargets gemessen um nicht mehr als +/-5 % (relativ) um einen Mittelwert streut.

Das erfindungsgemäße Verfahren zur Herstellung des Schichtsystems

In Bezug auf das Verfahren zur Herstellung des Schichtsystems wird die oben angegebene Aufgabe ausgehend von einem Verfahren der eingangs genannten Gattung erfindungsgemäß durch ein Verfahren gelöst, bei dem ein Sputtertarget mit einem Sauerstoffmangel gemäß der Erfindung eingesetzt wird, wobei zur Abscheidung einer Absorberschicht aus einem Oxid oder aus einem Oxinitrid mit unterstöchiometrischem Sauerstoffgehalt der Sputter-Atmosphäre ein Reaktivgas in Form von Sauerstoff und/oder Stickstoff beigemischt wird, derart, dass sich in der Sputter-Atmosphäre ein Reaktivgasgehalt von maximal 10 Vol.-%, bevorzugt maximal 5 Vol.-% einstellt.

Das erfindungsgemäße Verfahren zeichnet sich aus durch das Zusammenspiel einer nur wenig reaktiven Sputter-Atmosphäre einerseits und des Einsatzes eines Targets aus unterstöchiometrischem Oxid oder Oxinitrid andererseits. Die abgeschiedene Schicht unterscheidet sich in ihrer chemischen Zusammensetzung nicht wesentlich von der des eingesetzten Target-Materials. Dies erlaubt eine stabile Führung des Sputterprozesses und die reproduzierbare Einstellung der Eigenschaften der abgeschiedenen Schicht.

Dazu trägt auch eine besonders bevorzugte Modifikation dieser Verfahrensweise bei, bei der- jeweils bezogen auf ideale Stöchiometrie - sich der Anteil an Sauerstoff und Stickstoff im Material des Sputtertargets vom Anteil an Sauerstoff und Stickstoff im Oxid oder Oxinitrid der Absorberschicht nicht oder um maximal +-20%, bevorzugt um maximal +/-10%, unterscheidet.

Sowohl das Material des Sputtertargets insgesamt, also seine oxidische oder oxinitridische Phase und unter Berücksichtigung eines etwaigen Beitrags einer metallische Beimischung, als auch die herzustellende Absorberschicht zeigen einen Mangel an Sauerstoff oder Stickstoff - im Vergleich zu einem vollstöchiometrischen Material. Beim erfindungsgemäßen Verfahren ist vorgesehen, dass der Mangel an Sauerstoff im Targetmaterial so groß ist, oder nur geringfügig ausgeprägter ist als der Mangel an Sauerstoff in der Absorberschicht. Genauer gesagt, liegt der Anteil an Sauerstoff und Stickstoff im Material des Sputtertargets bei mindestens 50 %, bevorzugt bei mindestens 70 % des Anteils an Sauerstoff/Stickstoff in der Absorberschicht.

Dadurch ist das Targetmaterial unverändert oder mit nur geringer Aufoxidation in das unterstöchiometrische Oxid/Oxinitrid der Absorberschicht übertragbar. Dabei ist zu beachten, dass ein gewisser Sauerstoffverlust beim Sputterprozess einen kleinen Beitrag zur Einstellung der gewünschten Unterstöchiometrie der Absorberschicht liefern kann.

Bei einer besonders einfachen Verfahrensweise erfolgt die Abscheidung der Antireflexschicht und der Absorberschicht unter Einsatz derselben Target-Zusammensetzung, wobei die Sputter-Atmosphäre bei der Abscheidung der Antireflexschicht einen höheren Reaktivgasgehalt hat als bei der Abscheidung der Absorberschicht.

Die Reaktivgaszugabe bei der Abscheidung der Antireflexschicht ist dabei ausreichend hoch, dass die Antireflexschicht dielektrisch wird.

Ausführungsbeispiel

Nachfolgend wird die Erfindung anhand einer Patentzeichnung und eines Ausführungsbeispiels näher erläutert. Im Einzelnen zeigt:

**Figur 1**     eine schematische Darstellung des erfindungsgemäßen Schichtsystems in einem Querschnitt,
**Figur 2**     eine TEM-Aufnahme eines Schliffs des Schichtsystems in maximaler Vergrößerung,

**Figur 3**     ein Röntgenbeugungsdiagramm des Werkstoffs des Schichtsystems,

**Figur 4**     ein Diagramm zur spektralen Transmission und Reflexion des Schichtsystems, von der Substratseite aus.

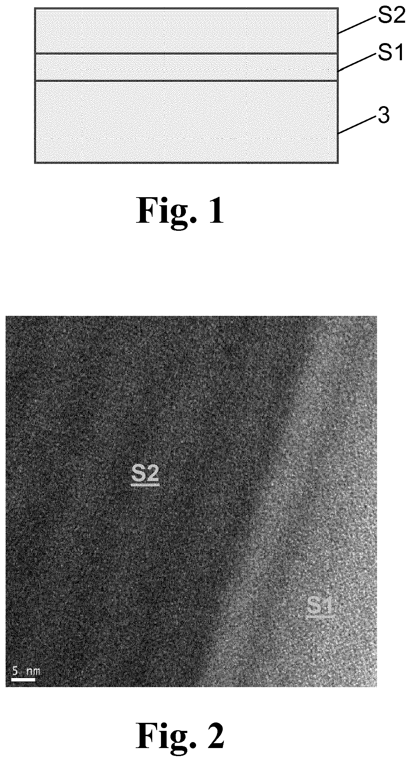

**Figur 1** zeigt schematisch ein aus zwei Schichten S1, S2 bestehendes Schichtsystem 1 gemäß der Offenbarung. Die erste Schicht ist eine auf einer transparenten Glasplatte 3 aufgebrachte Antireflexschicht S1, und die zweite Schicht ist eine auf der Antireflexschicht S1 erzeugte Absorberschicht S2

Die Schichten S1 und S2 bestehen jeweils aus einer Oxidschicht mit unterschiedlichem Sauerstoffmangel. Das Oxid enthält mindestens eines der Elemente Nb, Ti, V, Mo, W.

Der Sauerstoffgehalt der Antireflexschicht S1 liegt bei mindestens 94% des stöchiometrischen Sauerstoffgehalts. Der Sauerstoffgehalt der Absorberschicht S2 ist geringer und liegt im Bereich von 65 bis 90 % des stöchiometrischen Sauerstoffgehalts. Der Sauerstoffgehalt der Schichten wird mittels EPMA-Messungen (Electron Probe Microprobe Analysis) ermittelt. Dabei wird ein Elektronenstrahl auf die Probe gerichtet und die dabei erzeugte Röntgenstrahlung analysiert. Es kann gegen Standards kalibriert werden, so dass der relative Messfehler etwa bei 3-4%, liegt und der Sauerstoffgehalt der unterstöchiometrischen Schicht auf etwa +-1 At.% bestimmt werden kann. Um keine Messfehler durch das Substrat zu erhalten, sind hierfür am besten Schichten mit >1 $\mu$m Dicke herzustellen.

Die Schichtdicke der Antireflexschicht S1 beträgt 43 nm und die Schichtdicke der Absorberschicht S2 beträgt 170 nm. Im Ausführungsbeispiel wurden die Schicht S1 und S2 beide von einem Target gesputtert, das neben $Nb_2O_{4,99}$ noch 25 Vol.-% (entspricht 43,1 Gew.-%) Mo enthält.

Das Schichtsystem ist für einen Betrachter mit Blickrichtung von der Glasplatte 3 aus nahezu undurchsichtig und zugleich fast schwarz.

**Figur 2** zeigt eine TEM Aufnahme mit maximaler Auflösung von einer Schicht S2 die neben $Nb_2O_5$ noch 20 Vol.-% (entspricht 36,2 Gew.-%) Mo enthält. Es sind keine Metallausscheidungen zu erkennen.

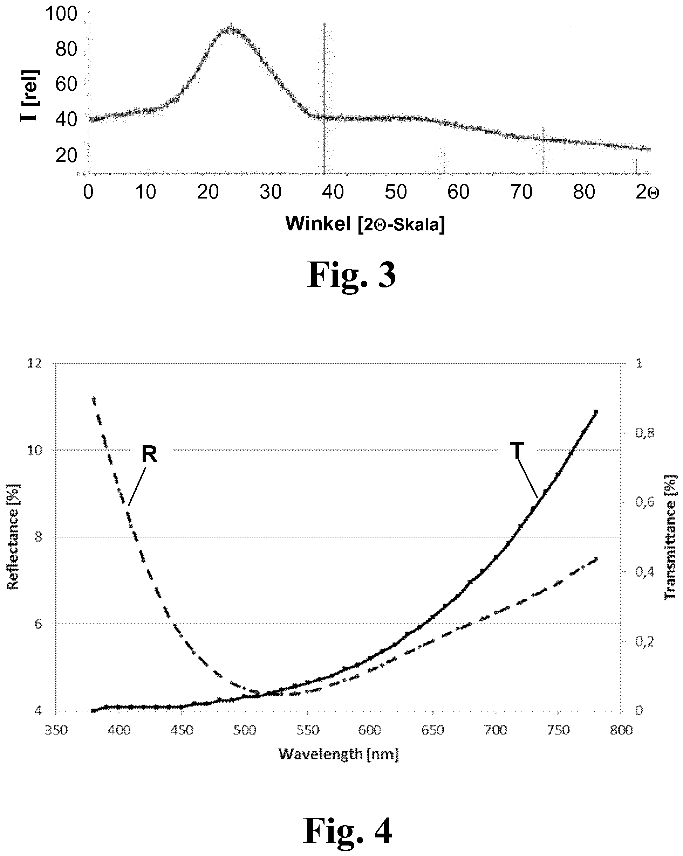

Dieses Ergebnis wird bestätigt durch das Röntgenbeugungsdiagramm der Schichtwerkstoffe in **Figur 3.** Es sind keine konkreten Beugungslinien zu erkennen, der Werkstoff ist röntgenamorph.

Beispiele für nach dem erfindungsgemäßen Verfahren erzeugte Schichtsysteme

Aus **Tabelle 1** ergeben sich die jeweiligen Metallgehalte des eingesetzten Sputtertertargets und Schichtdicken der Schichten S1 und S2 für das Schichtsystem aus $Nb_2O_5$ mit Mo, sowie die Abscheidebedingungen. Die Messergebnisse an den Schichtstapeln sind in **Tabelle 2** für die Transmission $T_V$ und Reflexion $R_v$ (abzüglich 4 % für die Reflexion an der Vorderseite des unbeschichteten Glassubstrats) sowie den Absorptionsindex kappa bei 550nm angegeben.

**Tabelle 1 (Abscheidebedingungen)**

| Nr | Matrix | Metall | S1 Mo [Gew.-%] | S1 d [nm] | 02 für S1 [sccm] | S2 Mo [Gew.-%] | S2 d [nm] | 02 für S2 [sccm] |
|---|---|---|---|---|---|---|---|---|
| 1 | $Nb_2O_5$ | Mo | 43,1 | 40 | 40 | 43,1 | 170 | 0 |
| 2 | $Nb_2O_5$ | Mo | 36,2 | 46 | 30 | 36,2 | 360 | 10 |
| 3 | $Nb_2O_5$ | Mo | 36,2 | 46 | 30 | 36,2 | 450 | 10 |
| 4 | $Nb_2O_5$ | Mo | 36,2 | 46 | 30 | 36,2 | 650 | 10 |
| 5 | $Nb_2O_5$ | Mo | 10,7 | 43 | 10 | 36,2 | 650 | 10 |

**Tabelle 2 (Schichteigenschaften)**

| Nr | Matrix | Metal | S1 Mo [Gew.-%] | S1 d [nm] | S2 Mo [Gew.-%] | S2 d [nm] | Rv [%] | Tv [%] | Kappa bei 550 nm |
|---|---|---|---|---|---|---|---|---|---|
| 1 | $Nb_2O_5$ | Mo | 43,1 | 40 | 43,1 | 170 | 0,9 | 0,08 | 1,78 |
| 2 | $Nb_2O_5$ | Mo | 36,2 | 46 | 36,2 | 360 | 0,9 | 0,15 | 0,75 |
| 3 | $Nb_2O_5$ | Mo | 36,2 | 46 | 36,2 | 450 | 1,0 | 0,02 | 0,75 |
| 4 | $Nb_2O_5$ | Mo | 36,2 | 46 | 36,2 | 650 | 0,9 | <0,01 | 0,75 |
| 5 | $Nb_2O_5$ | Mo | 10,7 | 43 | 36,2 | 650 | 1,2 | <0,01 | 0,75 |

Anmerkung zur Angabe des Gewichtsverhältnisses (Gew.-%) von Mo: Diese Angabe bezieht sich jeweils auf den Gehalt an Mo-Metall im Target-Werkstoff. In den Schichten und insbesondere in der Absorberschicht S2 bildet sich eine amorphe Struktur aus einem unterstöchiometrischen Oxid Nb-Mo-O$_x$ mit nicht exakt bestimmbarer Aufteilung des Sauerstoffs auf Nb und Mo.

Die Anforderungen hinsichtlich der visuellen Transmission im Wellenlängenbereich von 380 - 780 nm (Tv < 1 %, bevorzugt Tv <0,2%) sowie der visuellen Reflexion (Rv < 6 %, bevorzugt Rv < 2%) werden von allen Schichtsystemen erfüllt. Das Schichtsystem Nr. 5 mit niedrigem Mo-Gehalt für die Antireflexschicht S1 zeigt jedoch bereits eine merklich erhöhte visuelle Reflexion Rv.

Die optische Absorption der Schichtsysteme Nr. 2 bis 5 ist durch einen kappa-Wert von 0,75 (bei 550 nm) gekennzeichnet. Für besonders dünne hochabsorbierende Schichten ist das Schichtsystem Nr. 1 geeignet, dessen Absorption sich durch einen kappa-Wert deutlich größer als 1 auszeichnet.

Beispiele für nach anderen Verfahren erzeugte Schichtsysteme

Zum Vergleich sind in **Tabelle 3** Aufbau und Messergebnisse von Schichtsystemen zusammengefasst, die durch teilreaktives Sputtern metallischer Sputtertargets erzeugt worden sind.

**Tabelle 3 Schichteigenschaften**

| Nr | Schicht S1 | | | | Schicht S2 | | Eigenschaften | | |
|---|---|---|---|---|---|---|---|---|---|
| | Matrix | Metall | Mo (Gew.-%) | d [nm] | Matrix | D [nm] | Rv [%] | Tv [%] | Kappa bei 550n |
| 6 | Nb$_2$O$_5$ | Mo | 36,2 | 45 | NbO$_x$ | 400 | 0,7 | 0,09 | 0,751 |
| 7 | Nb$_2$O$_5$ | Mo | 43,1 | 49 | NbO$_x$ | 400 | 1,0 | 0,1 | 0,751 |
| 8 | Nb$_2$O$_5$ | Mo | 36,2 | 37 | TiO$_x$N$_y$ | 528 | 1,1 | 0,1 | 0,560 |
| 9 | Nb$_2$O$_5$ | Mo | 43,1 | 40 | TiO$_x$N$_y$ | 525 | 1,9 | 0,09 | 0,560 |
| 10 | Nb$_2$O$_5$ | Mo | 36,2 | 40 | WO$_x$N$_y$ | 650 | 1,4 | 0,1 | 0,460 |
| 11 | Nb$_2$O$_5$ | Mo | 43,1 | 45 | WO$_x$N$_y$ | 640 | 2,2 | 0,1 | 0,460 |

Der Vergleich der Tabellen 2 und 3 zeigt, dass die durch teilreaktives Sputtern metallischer Targets erzeugten Schichtsysteme 6 bis 11 keine höhere Absorption (kappa) zeigen, sondern tendenziell sogar geringere Absorptionen als die Schichtsysteme 1 bis 5 von Tabelle 2, die anhand es erfindungsgemäßen Verfahrens durch Sputtern leitfähigen Oxidtargets mit deutlichen Metallanteilen erzeugt worden sind. Das teilreaktive Sputtern metallischer Targets hat zudem Nachteile in der Prozessführung wegen des hohen Anteils an reaktivem Gas in der Sputter-Atmosphäre und daraus resultierender Instabilität des Beschichtungsprozesses.

Ausführungsbeispiele zum erfindungsgemäßen Verfahren

Nachfolgend wird ein Verfahren zur Herstellung der Schichtstruktur anhand eines Beispiels näher erläutert: Eine Pulvermischung aus 64 Gew.-% Nb$_2$O$_{4,99}$ und 36 Gew.-% Mo mit einer mittleren Korngröße von 25 $\mu$m wird in einem Taumel-Mischer 1h lang intensiv gemischt, so dass sich eine feine und monodisperse Verteilung der Mo-Partikel in Nb$_2$O$_{4,99}$ ergibt. Anschließend wird diese Mischung in eine Graphitform mit einem Durchmesser von 75 mm und einer Höhe von 15 mm gefüllt. Die Ronde wird durch Heißpressen unter reduzierenden Bedingungen bei 1200°C und 30 MPa zu mehr als 85 % der theoretischen Dichte verdichtet. Das so erhaltene Gefüge besteht aus einer Nb$_2$O$_{4,99}$-Matrix, in die Mo-Partikel mit einer mittleren Korngröße von 25 $\mu$m eingebettet sind.

Analog wird ein zweites Sputtertarget mit 57 Gew.-% Nb$_2$O$_{4,99}$ und 43 Gew.-% Mo hergestellt sowie ein drittes mit 89 Gew.-% Nb$_2$O$_{4,99}$ und 11 Gew.-% Mo. Beim letztgenannten Sputtertarget wurde zur Herstellung einer besondere geleichmäßigen Mo-Verteilung ein Mo-Pulver mit <10$\mu$m) Korngröße gewählt.

Die Sputtertargets weisen einen spezifischen elektrischen Widerstand von weniger als 1 Ohm*cm auf.

Unter Verwendung dieser Sputtertargets wird die zweilagige Schichtstruktur S1, S2 auf einem Glassubstrat 3 der Größe 2 cm x 2 cm und einer Dicke von 1,0 mm mittels DC-Sputtern aufgebracht. Auf das Glassubstrat 3 wird zunächst eine erste Schicht S1, aufgebracht und darauf anschließend eine zweite Schicht S2. Schichtdicken, Targetwerkstoff und Sauerstofffluss während des Sputterns sind Tabelle 1 zu entnehmen.

Die übrigen Sputterparameter sind dabei wie folgt:

| | |
|---|---|
| Restgasdruck: | $2 * 10^{-6}$ mbar |
| Prozessdruck: | $3 * 10^{-3}$ mbar bei 200 sccm Argon |
| Spezifische Kathodenleistung: | 5 W/cm$^2$ |

Der Sauerstofffluss wurde dabei für die Antireflexschicht S1 so gewählt, dass sie nahezu transparent wurde.

Bei der Absorberschicht S2 werden hingegen die besten Ergebnisse in Bezug auf hohe optische Absorption (beziehungsweise geringe Schichtdicke bei gegebener Absorption) dann erhalten, wenn beim Sputtern kein weiterer Sauerstoff hinzugefügt wird.

Bei den in Tabelle 2 genannten Schichtsystemen wird nur eine Sputtertarget-Zusammensetzung zur Abscheidung beider Schichten benötigt. Die unterschiedlichen Sauerstoff-Stöchiometrien werden dabei nur durch den Sauerstoffstrom beim Sputtern eingestellt. Dabei entspricht ein Sauerstoffstrom von z.B. 30sccm (das sind im Ausführungsbeispiel 13 Vol.-% Sauerstoff in der Sputter-Atmosphäre) einem Sauerstoffstrom, der technologisch noch problemlos gefahren werden kann.

Die Antireflexschicht S1 ist unter diesen Bedingungen nahezu volloxidisch, während die Absorberschicht S2 in etwa den Sauerstoffmangel des Targets aufweist. Um voll dielektrische Schichten von einem volloxidischen Target zu erhalten, ist unter den gegebenen Bedingungen ein geringer anlagenspezifischer Sauerstoffstrom erforderlich, um den Verlust an Sauerstoff durch die Pumpen auszugleichen. Um aus einem Target mit Sauerstoffmangel dielektrische Schichten abzuscheiden, bedarf es in erster Näherung eines Sauerstoffflusses proportional zu dem Metallgehalt (Sauerstoffmangel) des eingesetzten Targets für diese Schicht. Für die eingesetzte Laboranlage und eine Schicht aus $Nb_2O_{4,99}$+Mo gilt näherungsweise:

$$\text{Sauerstoff-Fluss in sccm} = \text{Mo-Gehalt des Targets in Gew.-\%.}$$

Für andere Sputteranlagen und Target-Mischungen ergeben sich andere Werte, die anhand eines Versuches zunächst zu ermitteln und der Sauerstofffluss dementsprechend anzupassen sind. Die Eigenschaften der so hergestellten Schichtstruktur sind in Tabelle 2 genannt und können folgendermaßen zusammengefasst werden:

- Visuelle Reflexion (nach Abzug von ca. 4 % Reflexion durch Messung von der unbeschichteten Substratseite): <1%.

- Visuelle Transmission: <0,2 %

- Absorptionskoeffizient Kappa: 0,75-1,78.

Die Absorption der $Nb_2O_5$-Mo-Schichtstruktur insgesamt liegt damit höher als 99,8 %.

In **Figur 4** sind für das Schichtsystem Glas / Mo-NbOx / NbOx gemäß Probe Nr. 1 der Tabellen 1 und 2 die Transmission T in [%] und die Reflexion R in [%] gegen die Messwellenlänge λ in [nm] aufgetragen. Die Reflexion an der nicht entspiegelten Vorderseite des Glas-Substrats ist hier noch nicht abgezogen. Demnach liegt die Transmission T über einen breiten Wellenlängenbereich von 380 nm bis 780 nm unterhalb von 1 %. Die gemessene Reflexion liegt dabei unterhalb von 11%, so dass sich nach Abzug eines Reflexionswertes von 4 %, der auf Reflexion an der nicht entspiegelten Glasplatten-Vorderseite zurückzuführen ist, eine tatsächlich dem Schichtsystem zuzuschreibende Reflexion unterhalb von 7 % ergibt.

Bei Lagerung der Schichtstruktur bei 18-24°C und 50-60 % relativer Luftfeuchtigkeit über bis zu 5 Tage haben sich die optischen Eigenschaften nur unwesentlich verändert. Die Änderung von Rv und Tv lag jeweils unterhalb der Nachweisgrenze.

Die so erzeugte Schicht lässt sich ohne Bildung störender Metallpartikel z.B. über Ätzen in Lösungen aus KOH+$H_2O_2$ strukturieren. Auch bei anderen Ätzverfahren, wie beispielsweise Sputterätzen, zeigt sich keinerlei störende Partikelbildung.

**Patentansprüche**

1. Sputtertarget, welches aus einem oxidischen Werkstoff mit Sauerstoffmangel besteht, der durch eine reduzierte Oxidphase von unterstöchiometrischem Oxid oder Oxinitrid auf der Basis von $Nb_2O_{5-x}$, $TiO_{2-x}$, $MoO_{3-x}$, $WO_{3-x}$, $V_2O_{5-x}$ (x>0) oder deren Mischungen zusammen mit einer metallischen Beimischung eingestellt wird, **dadurch gekennzeichnet, dass**

das Sputtertarget entweder Nb und Mo sowie mindestens eines deren Oxide enthält oder Ti und Mo sowie mindestens eines deren Oxide enthält.

2. Sputtertarget nach Anspruch 1, **dadurch gekennzeichnet, dass** der Sauerstoffmangel durch einen Reduktionsgrad definiert ist, bei dem der Sauerstoffgehalt zwischen 65 und 90 %, vorzugsweise zwischen 70 und 85 % des stöchiometrischen Sauerstoffgehalts liegt.

3. Sputtertarget nach Anspruch einem der vorhergehenden Ansprüche, **dadurch gekennzeichnet, dass** die metallische Beimischung ein oder mehrere Elemente aus der Gruppe Nb, Ti, Mo, W, Ta, V enthält.

4. Sputtertarget nach Anspruch 2 und 3, **dadurch gekennzeichnet, dass** die metallische Beimischung mindestens 50 %, vorzugsweise mindestens 70 % des Reduktionsgrades bewirkt.

5. Sputtertarget nach Anspruch 2, **dadurch gekennzeichnet, dass** der Reduktionsgrad an mindestens 5 Stellen über die Dicke des Sputtertargets gemessen um nicht mehr als +-5 % (relativ) um einen Mittelwert streut.

6. Sputtertarget nach einem der vorhergehenden Ansprüche, **dadurch gekennzeichnet, dass** die metallische Beimischung einen Metallgehalt definiert, der an mindestens 5 Stellen über die Dicke des Sputtertargets gemessen um nicht mehr als +-5 % um einen Mittelwert streut.

7. Sputtertarget nach einem der vorhergehenden Ansprüche, **dadurch gekennzeichnet, dass** es Nb und Mo sowie Nioboxid mit unterstöchiometrischem Sauerstoffgehalt enthält.

8. Sputtertarget nach Anspruch 7, **dadurch gekennzeichnet, dass** es aus $Nb_2O_{5-x}$ und Mo besteht mit x=0,01 - 0,3, wobei der Mo-Gehalt vorzugsweise zwischen 28 und 60 Gew.-%, bevorzugt zwischen 36 und 50 Gew.-%, beträgt.

9. Sputtertarget nach einem der vorhergehenden Ansprüche, **dadurch gekennzeichnet, dass** es Ti und Mo sowie mindestens eines deren Oxide enthält, wobei der Mo-Gehalt zwischen 30 und 65 Gew.-%, bevorzugt zwischen 40 und 55 Gew.-%, beträgt.

10. Sputtertarget nach einem der vorhergehenden Ansprüche, **dadurch gekennzeichnet, dass** sein elektrischer Widerstand weniger als 10 Ohm*cm, bevorzugt weniger als 1 Ohm*cm beträgt.

11. Verfahren zur Herstellung eines Licht absorbierenden Schichtsystems aus mindestens zwei Schichten auf einem Träger (3), von denen eine Schicht eine Antireflexschicht (S1) ist, die aus einem dielektrischen Werkstoff besteht, und mindestens eine weitere eine Absorberschicht (S2) ist, wobei die Absorberschicht aus einem Oxid oder aus einem Oxinitrid mit unterstöchiometrischem Sauerstoffgehalt besteht, und wobei das Schichtsystem insgesamt im Wellenlängenbereich von 380 bis 780 nm eine visuelle Transmission Tv von weniger als 1 % und eine visuelle Reflexion Rv von weniger als 6 % aufweist sowie eine optische Absorption hat, die durch einen Absorptionsindex kappa von mindestens 0,70 bei einer Wellenlänge von 550 nm gekennzeichnet ist, umfassend die Abscheidung der Antireflexschicht (S1) und die Abscheidung der Absorberschicht (S2) durch DC- oder MF-Sputtern eines Sputtertargets in einer Sputter-Atmosphäre, die ein Edelgas enthält, **dadurch gekennzeichnet, dass** das Sputtertarget nach einem oder mehreren der Ansprüche 1 bis 10 ausgeführt ist, und dass zur Abscheidung einer Absorberschicht aus einem Oxid oder aus einem Oxinitrid mit unterstöchiometrischem Sauerstoffgehalt der Sputter-Atmosphäre ein Reaktivgas in Form von Sauerstoff und/oder Stickstoff beigemischt wird, derart, dass sich in der Sputter-Atmosphäre ein Reaktivgasgehalt von maximal 10 Vol.-% einstellt.

12. Verfahren nach Anspruch 11, **dadurch gekennzeichnet, dass** der Sputter-Atmosphäre ein Reaktivgas in Form von Sauerstoff und/oder Stickstoff beigemischt wird, derart, dass sich in der Sputter-Atmosphäre ein Reaktivgasgehalt von maximal 5 Vol.-% einstellt.

13. Verfahren nach Anspruch11 oder 12, **dadurch gekennzeichnet, dass** - jeweils bezogen auf eine voll-stöchiometrische Schicht - sich der Anteil an Sauerstoff und Stickstoff im Material des Sputtertargets vom Anteil an Sauerstoff und Stickstoff im Oxid oder Oxinitrid der Absorberschicht nicht oder um maximal +-20%, bevorzugt um maximal +/-10%, unterscheidet.

14. Verfahren nach einem der Ansprüchel 1 bis 13, **dadurch gekennzeichnet, dass** die Abscheidung der Antireflexschicht und der Absorberschicht unter Einsatz derselben Target-Zusammensetzung erfolgt, wobei die Sputter-

**EP 2 912 500 B1**

Atmosphäre bei der Abscheidung der Antireflexschicht einen höheren Reaktivgasgehalt hat als bei der Abscheidung der Absorberschicht.

**Claims**

1. A sputtering target, consisting of an oxidic material having oxygen deficiency, which is set by a reduced oxide phase of hypostoichiometric oxide or oxynitride based on $Nb_2O_{5-x}$, $TiO_{2-x}$, $MoO_{3-x}$, $WO_{3-x}$, $V_2O_{5-x}$ (x>0), or the mixtures thereof, together with a metallic admixture, **characterized in that** the sputtering target comprises either Nb and Mo as well as at least one of the oxides thereof, or Ti and Mo as well as at least one of the oxides thereof.

2. The sputtering target according to claim 1, **characterized in that** the oxygen deficiency is defined by a degree of reduction at which the oxygen content is between 65 and 90%, and preferably between 70 and 85% of the stoichiometric oxygen content.

3. The sputtering target according to any one of the preceding claims, **characterized in that** the metallic admixture comprises one or more elements from the group consisting of Nb, Ti, Mo, W, Ta and V.

4. The sputtering target according to claims 2 and 3, **characterized in that** the metallic admixture brings about at least 50%, and preferably at least 70% of the degree of reduction.

5. The sputtering target according to claim 2, **characterized in that** the degree of reduction in at least 5 locations, measured across the thickness of the sputtering target, does not vary by more than +/-5% (in relative terms) around a mean value.

6. The sputtering target according to any one of the preceding claims, **characterized in that** the metallic admixture defines a metal content that in at least 5 locations, measured across the thickness of the sputtering target, does not vary by more than +/-5% around a mean value.

7. The sputtering target according to any one of the preceding claims, **characterized by** comprising Nb and Mo as well as niobium oxide having a hypo-stoichiometric oxygen content.

8. The sputtering target according to claim 7, **characterized by** comprising $Nb_2O_{5-x}$ and Mo, where x = 0.01 to 0.3, the Mo content preferably ranging between 28 and 60 wt.%, and preferably between 36 and 50 wt.%.

9. The sputtering target according to any one of the preceding claims, **characterized by** comprising Ti and Mo as well as at least one of the oxides thereof, the Mo content preferably ranging between 30 and 65 wt.%, and preferably between 40 and 55 wt.%.

10. The sputtering target according to any one of the preceding claims, **characterized in that** the electrical resistivity thereof is less than 10 ohm*cm, and preferably less than 1 ohm*cm.

11. A method for producing a light-absorbing layer system comprising at least two layers on a carrier (3), of which one layer is an anti-reflection layer (S1), which comprises a dielectric material, and at least one further is an absorber layer (S2), the absorber layer comprising an oxide or an oxynitride having a hypo-stoichiometric oxygen content, and the layer system overall, in the wavelength range of 380 to 780 nm, having a visible transmittance Tv of less than 1% and a visible reflectance Rv of less than 6% and an optical absorption that is **characterized by** an absorption index kappa of at least 0.70 at a wavelength of 550 nm, comprising the deposition of the anti-reflection layer (S1) and the deposition of the absorber layer (S2) by way of DC or MF sputtering of a sputtering target in a sputtering atmosphere containing a noble gas, **characterized in that** the sputtering target is designed according to any one or more of claims 1 to 10, and, for the deposition of an absorber layer made of an oxide or made of an oxynitride having a hypo-stoichiometric oxygen content, a reactive gas in the form of oxygen and/or nitrogen is admixed to the sputtering atmosphere in such a way that a reactive gas content of no more than 10 vol.% develops in the sputtering atmosphere.

12. The method according to claim 11, **characterized in that** a reactive gas in the form of oxygen and/or nitrogen is admixed to the sputtering atmosphere in such a way that a reactive gas content of no more than 5 vol.% develops in the sputtering atmosphere.

13. The method according to claim 11 or 12, **characterized in that** - in each case based on a fully stoichiometric layer - the content of oxygen and nitrogen in the material of the sputtering target does not differ, or differs by no more than +/-20%, and preferably by no more than +/-10%, from the content of oxygen and nitrogen in the oxide or oxynitride of the absorber layer.

14. The method according to any one of claims 11 to 13, **characterized in that** the deposition of the anti-reflection layer and of the absorber layer takes place using the same target composition, the sputtering atmosphere during the deposition of the anti-reflection layer having a higher reactive gas content than during the deposition of the absorber layer.

**Revendications**

1. Cible de pulvérisation cathodique, qui est constituée d'un matériau de type oxyde avec déficit en oxygène, qui est ajusté par une phase oxyde réduite d'oxyde ou d'oxynitrure sous-stoechiométrique à base de $Nb_2O_{5-x}$, de $TiO_{2-x}$, de $MoO_{3-x}$, de $WO_{3-x}$, de $V_2O_{5-x}$ (x>0) ou de mélanges de ceux-ci, avec un additif métallique, **caractérisée en ce que** la cible de pulvérisation cathodique ou bien contient du Nb et du Mo ainsi qu'au moins l'un de leurs oxydes, ou bien du Ti et du Mo ainsi qu'au moins l'un de leurs oxydes.

2. Cible de pulvérisation cathodique selon la revendication 1, **caractérisée en ce que** le déficit en oxygène est défini par un degré de réduction pour lequel la teneur en oxygène est comprise entre 65 et 90 %, de préférence entre 70 et 85 % de la teneur stoechiométrique en oxygène.

3. Cible de pulvérisation cathodique selon l'une des revendications précédentes, **caractérisée en ce que** l'additif métallique contient un ou plusieurs éléments du groupe Nb, Ti, Mo, W, Ta, V.

4. Cible de pulvérisation cathodique selon les revendications 2 et 3, **caractérisée en ce que** l'additif métallique assure au moins 50 %, de préférence au moins 70 % du degré de réduction.

5. Cible de pulvérisation cathodique selon la revendication 2, **caractérisée en ce que** le degré de réduction se répartit, en au moins 5 points, la mesure étant effectuée sur l'épaisseur de la cible de pulvérisation cathodique, selon une valeur non supérieure à $\pm 5$ % (en valeur relative) autour d'une valeur moyenne.

6. Cible de pulvérisation cathodique selon l'une des revendications précédentes, **caractérisée en ce que** l'additif métallique définit une teneur en métal qui se répartit, en au moins 5 points, la mesure étant effectuée sur l'épaisseur de la cible de pulvérisation cathodique, selon une valeur non supérieure à $\pm 5$ % autour d'une valeur moyenne.

7. Cible de pulvérisation cathodique selon l'une des revendications précédentes, **caractérisée en ce qu'**elle contient du Nb et du Mo, ainsi que de l'oxyde de niobium, avec une teneur sous-stoechiométrique en oxygène.

8. Cible de pulvérisation cathodique selon la revendication 7, **caractérisée en ce qu'**elle est constituée de $Nb_2O_{5-x}$ et de Mo, avec x=0,01 à 0,3, la teneur en Mo étant de préférence comprise entre 28 et 60 % en poids, préférentiellement entre 36 et 50 % en poids.

9. Cible de pulvérisation cathodique selon l'une des revendications précédentes, **caractérisée en ce qu'**elle contient du Ti et du Mo, ainsi qu'au moins l'un de leurs oxydes, la teneur en Mo étant comprise entre 30 et 65 % en poids, de préférence entre 40 et 55 % en poids.

10. Cible de pulvérisation cathodique selon l'une des revendications précédentes, **caractérisée en ce que** sa résistance électrique est inférieure à 10 Ohm*cm, de préférence inférieure à 1 Ohm*cm.

11. Procédé de fabrication d'un système de couches absorbant la lumière, constitué d'au moins deux couches sur un support (3), dont l'une est une couche antiréfléchissante (S1), qui est constituée d'un matériau diélectrique, et dont au moins une autre couche est une couche absorbante (S2), la couche absorbante étant constituée d'un oxyde ou d'un oxynitrure ayant une teneur sous-stoechiométrique en oxygène, et

le système de couches présentant globalement, dans la plage de longueurs d'onde de 380 à 780 nm, un facteur de transmission dans le visible Tv inférieur à 1 % et un facteur de réflexion dans le visible Rv inférieur à 6 %, ainsi qu'une absorption optique qui est **caractérisée par** un indice d'absorption kappa d'au moins 0,70 à une longueur d'onde de 550 nm, comprenant le dépôt de la couche antiréfléchissante (S1) et le dépôt de la couche absorbante (S2), par pulvérisation cathodique DC ou MF d'une cible de pulvérisation cathodique dans une atmosphère de pulvérisation cathodique qui contient un gaz rare,
**caractérisé en ce que** la cible de pulvérisation cathodique est réalisée selon l'une ou plusieurs des revendications 1 à 10, et **en ce que**, pour le dépôt d'une couche absorbante constituée d'un oxyde ou d'un oxyniture, l'atmosphère de pulvérisation cathodique présentant une teneur sous-stoechiométrique en oxygène, on ajoute un gaz réactif sous forme d'oxygène et/ou d'azote, de telle sorte que la teneur de l'atmosphère de pulvérisation cathodique en gaz réactif soit ajustée à une valeur maximale de 10 % en volume.

12. Procédé selon la revendication 11, **caractérisé en ce qu'**on ajoute à l'atmosphère de pulvérisation cathodique un gaz réactif sous forme d'oxygène et/ou d'azote, de telle sorte que la teneur de l'atmosphère de pulvérisation cathodique en gaz réactif soit ajustée au maximum à 5 % en volume.

13. Procédé selon la revendication 11 ou 12, **caractérisé en ce que**, dans chaque cas pour une couche entièrement stoechiométrique, la différence entre la proportion d'oxygène et d'azote dans le matériau de la cible de pulvérisation cathodique et la proportion d'oxygène et d'azote dans l'oxyde ou l'oxynitrure de la couche absorbante est nulle, ou est au maximum de $\pm$ 20 %, de préférence au maximum de $\pm$ 10 %.

14. Procédé selon l'une des revendications 11 à 13, **caractérisé en ce que** le dépôt de la couche antiréfléchissante et de la couche absorbante s'effectue par utilisation de la même composition de la cible, l'atmosphère de pulvérisation cathodique présentant, lors du dépôt de la couche antiréfléchissante, une teneur en gaz réactif plus élevée que lors du dépôt de la couche absorbante.

**Fig. 1**

**Fig. 2**

**Fig. 3**

**Fig. 4**

**IN DER BESCHREIBUNG AUFGEFÜHRTE DOKUMENTE**

**In der Beschreibung aufgeführte Patentdokumente**

- EP 0852266 A

**In der Beschreibung aufgeführte Nicht-Patentliteratur**

- **KENNEDY, C.E.** Review of Mid- to High-Temperature Solar Selective Absorber Materials. *NREL Technical Report,* Juli 2002